# EUROPEAN PATENT APPLICATION

(11) **EP 2 985 782 A1**
(43) Date of publication of application: **17.02.2016**
(21) Application number: 13876898.1
(22) Date of filing: 04.03.2013
(51) Int. Cl.: H01L 21/301

(54) **DICING SHEET SUBSTRATE FILM, AND DICING SHEET PROVIDED WITH SAID SUBSTRATE FILM**

(71) Applicant: Lintec Corporation, Tokyo 173-0001 (JP)
(72) Inventor: TAYA Naoki, Tokyo 173-0001 (JP); UEDA Masashi, Tokyo 173-0001 (JP); ITO Masaharu, Tokyo 173-0001 (JP)
(74) Representative: Raynor, Stuart Andrew
(86) International application number: PCT/JP2013/055840
(87) International publication number: WO 2014/136181

(57) **Abstract**

A base film (2) for a dicing sheet is provided which can suppress dicing debris from generating during the dicing of a cut object in the full-cut dicing without imparting physical energy, such as electron beam or γ ray, and which has an enhanced expanding property in the expanding process. The base film (2) for a dicing sheet comprises a resin layer (A) that contains a polyethylene and an ethylene-tetracyclododecene copolymer. A dicing sheet that comprises the base film for a dicing sheet is also provided.

## Description

### [Technical Field]

The present invention relates to a dicing sheet to which a cut object such as a semiconductor wafer is applied when the cut object is cut and separated into small element pieces, and also relates to a base film used for the dicing sheet.

### [Background Art]

Semiconductor wafers such as silicon and gallium arsenide wafers and various types of packages (which may be collectively referred to as "cut object(s)" herein) are manufactured in a large diameter state, and these are cut and separated (diced) into small element pieces (referred to as "chip(s)" hereinafter).

A cut object to be supplied to the dicing process may be such that, for the purpose of ensuring the handling property of the cut object and chips in the dicing process and subsequent processes, a dicing sheet comprising a base film and a pressure-sensitive adhesive layer provided thereon is preliminarily applied to a surface of the cut object opposite to the side which a cutting tool for cutting comes close to. Such a dicing sheet may typically use polyolefin-based film or polyvinyl chloride-based film as the base film, for example.

According to commonly-used full-cut dicing as a specific method for the dicing process, a rotating round blade (dicing blade) is used for cutting a cut object. In the full-cut dicing, to ensure that the cut object applied thereto with the dicing sheet is completely cut over the entire surface, the pressure-sensitive adhesive layer may also be cut beyond the cut object, and a part of the base film may further be cut.

During this operation, dicing debris comprising material that constitutes the pressure-sensitive adhesive layer and the base film may arise from the dicing sheet, and the obtained chips may be contaminated by the dicing debris. One form of such dicing debris is filament-like dicing debris that attaches onto a dicing line or to an area near the cross-section of each chip separated by dicing. When step-cutting method is performed to cut the cut object using different two types of dicing blade, such filament-like dicing debris may in particular be significantly generated, thus being problematic.

If the chip is enclosed in a package while a large amount of the filament-like dicing debris as described above remains on the chip, then the filament-like dicing debris attached to the chip will be decomposed by heat used for the enclosing, and the thermally decomposed substance may destroy the package and/or cause operational failure in a device incorporated therein with the chip. Such filament-like dicing debris is difficult to be removed by washing, and the yield of the dicing process will thus be remarkably reduced due to the occurrence of filament-like dicing debris.

When dicing a package as the cut object in which plural chips are enclosed by using cured resin, a dicing blade having a thicker blade width is used and the cutting depth in dicing also becomes deeper than the case of dicing a semiconductor wafer. Consequently, the amount of the base film to be cut and removed during the dicing may increase compared with the case of a semiconductor wafer, and this may result in a tendency that the generated amount of filament-like dicing debris also increases. Thus, the filament-like dicing debris may have to be prevented from occurring when dicing is performed by using a dicing sheet.

After the dicing process, the cut object having been cut may then be subjected to various processes, such as washing, expanding and picking-up processes. As such, it is further required for a dicing sheet to have an enhanced expanding property in the expanding process.

To suppress the occurrence of such dicing debris, Patent Literature 1 discloses an invention which uses, as the base film of a dicing sheet, a polyolefin-based film having been exposed to electron beam or γ (gamma) ray with 1-80 Mrad. In this invention, it appears that a resin that constitutes the base film is crosslinked through the exposure to electron beam or γ ray thereby to suppress the dicing debris from being generated.

Patent Literature 1 exemplifies, as materials for the polyolefin-based film to be exposed to electron beam or γ ray, resins such as polyethylene, polypropylene, polymethylpentene, ethylene-vinyl acetate copolymer, ethylene-(meth) acrylic acid copolymer, ethylene-methyl (meth)acrylate copolymer, ethylene-ethyl (meth)acrylate copolymer, ethylene-ionomer copolymer, ethylene-vinyl alcohol copolymer, and polybutene.

Patent Literature 2 exemplifies a tape for dicing a semiconductor in which: the tape is obtained by applying a pressure-sensitive adhesive on one surface of a base film; the base film comprises at least two layers; the melting point of a resin in a layer that contacts with the pressure-sensitive adhesive layer of the base film is 130-240°C; at least one layer of the two layers is a resin composition layer that contacts with the lower surface of the layer contacting with the pressure-sensitive adhesive layer; and the resin composition layer comprises 20-400 mass parts of hydrogen-added styrene-butadiene copolymer to 100 mass parts of polypropylene-based resin.

Patent Literature 3 discloses, as a film having an expanding property in the expanding process, a dicing film comprising: a base material layer that contains random polypropylene and olefin-based elastomer; and a pressure-sensitive adhesive layer laminated on the base material layer.

### [Prior Art Literature]

### [Patent Literature]

[Patent Literature 1] JP05-211234A
[Patent Literature 2] JP2005-174963A
[Patent Literature 3] JP2011-216595A

### [Summary of the Invention]

### [Problems to be solved by the Invention]

However, the film described in Patent Literature 1 has a tendency that the production cost increases compared with that of a standard base film, because the exposure to electron beam or γ ray is performed after the resin as described above is once formed into a film-like shape, and an additional process for production is required. The base film of Patent Literature 2 is not able to sufficiently prevent filament-like dicing debris from generating. The dicing film described in Patent Literature 3 has an enhanced expanding property in the expanding process, but is not able to sufficiently prevent filament-like dicing debris from generating.

The present invention has been created in view of such circumstances, and objects of the present invention include providing a base film for a dicing sheet which is to be a constitutional element of a dicing sheet capable of suppressing the occurrence of dicing debris, in particular filament-like dicing debris, during the dicing of a cut object in the full-cut dicing without imparting physical energy, such as electron beam or γ ray, and which has an enhanced expanding property in the expanding process (referred also to as "expandability" in the present description), and also providing a dicing sheet that comprises the base film for a dicing sheet.

### [Means for solving the Problems]

In order to solve the above problems, first, the present invention provides a base film for a dicing sheet, the base film comprising a resin layer (A), wherein the resin layer (A) contains a polyethylene and an ethylene-tetracyclododecene copolymer (Invention 1).

In the above invention (Invention 1), it may be preferred that the polyethylene has a content of 50 mass% or more and 90 mass% or less and the ethylene-tetracyclododecene copolymer has a content of 10 mass% or more and 50 mass% or less to total resin components contained in the resin layer (A) (Invention 2).

In the above inventions (Inventions 1, 2), it may be preferred that the ethylene-tetracyclododecene copolymer has a constitutional unit originated from tetracyclododecene of 15 mol% or more and 45 mol% or less (where the total of a constitutional unit originated from ethylene and the constitutional unit originated from tetracyclododecene is 100 mol%) (Invention 3).

In the above inventions (Inventions 1 to 3), it may be preferred that the base film further comprises a resin layer (B) placed at one main surface side of the resin layer (A) and the resin layer (B) comprises at least one layer (Invention 4).

In the above invention (Invention 4), it may be preferred that the resin layer (B) comprises at least one of ethylene-(meth)acrylic acid ester copolymer and ethylene-(meth)acrylic acid copolymer (Invention 5).

Second, the present invention provides a dicing sheet comprising: the base film according to the above inventions (Inventions 1 to 5); and a pressure-sensitive adhesive layer placed on one main surface of the base film (Invention 6).

In the above invention (Invention 6), it may be preferred that the pressure-sensitive adhesive layer is placed on the resin layer (A) of the base film (Invention 7).

Third, the present invention provides a dicing sheet comprising: the base film according to the above inventions (Inventions 4, 5); and a pressure-sensitive adhesive layer placed on one main surface of the base film, wherein the resin layer (A) is placed more proximal to the pressure-sensitive adhesive layer than the resin layer (B) (Invention 8).

### [Advantageous Effect of the Invention]

According to the base film for a dicing sheet and the dicing sheet of the present invention, dicing debris that is generated during dicing of a cut object can effectively be reduced in the full-cut dicing, especially in full-cut dicing using step-cutting method, without imparting physical energy, such as electron beam or γ ray, and a base film can be obtained which has enhanced expandability in the expanding process.

### [Brief Description of Drawings]

[FIG. 1] FIG. 1 is a cross-sectional view of a dicing sheet according to one embodiment of the present invention.
[FIG. 2] FIG. 2 is a cross-sectional view of a dicing sheet according to another embodiment of the present invention.

### [Embodiments for Carrying out the Invention]

Description will hereinafter be directed to constitutional elements of the base film and the dicing sheet according to one embodiment of the present invention and a production method for them.

### 1. Base film

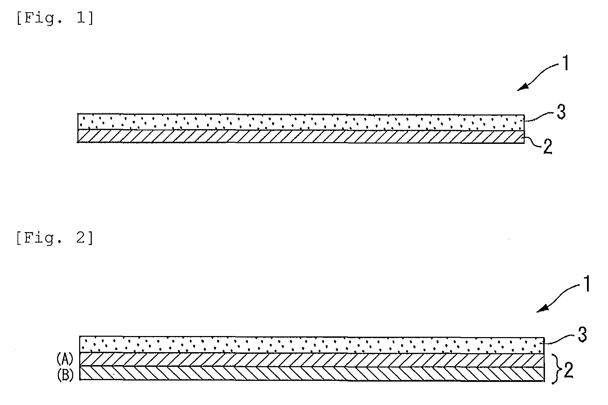

As shown in FIG. 1, base film 2 according to one embodiment of the present embodiment is to be used as one of constitutional elements of dishing sheet 1 according to one embodiment of the present invention. The dicing sheet 1 comprises, as a basic configuration, the base film 2 and a pressure-sensitive adhesive layer 3. This base film 2 comprises a resin layer (A), and may further comprise a resin layer (B) according to another embodiment (FIG. 2) as will be described later.

### (1) Resin layer (A)

The base film 2 according to the present embodiment may have a single layer structure or a multilayer structure so long as the base film comprises the resin layer (A). When the base film 2 comprises a single resin layer, the resin layer (A) as a single layer is the base film 2. When the base film 2 has a multilayer structure, the location of the resin layer (A) is not particularly limited, but it may be preferred that at least one of main surfaces of the base film 2 comprises the surface of the above resin layer (A). In this case, for forming the pressure-sensitive adhesive layer 3 on the base film 2 thereby to form the dicing sheet 1, the pressure-sensitive adhesive layer 3 may be formed on the resin layer (A). This may allow the occurrence of dicing debris to sufficiently be suppressed during dicing of a cut object.

The resin layer (A) possessed by the base film 2 according to the present embodiment contains a polyethylene and an ethylene-tetracyclododecene copolymer.

### (1-1) Polyethylene

The resin layer (A) of the base film 2 according to the present embodiment contains the polyethylene, and can thereby give enhanced blocking prevention functionality and expandability to the base film 2.

The above polyethylene may be a homopolymer of ethylene or a copolymer obtained by having ethylene as one type of monomers. If the polyethylene is a copolymer, then the content ratio in terms of monomer of a constitutional unit originated from ethylene in the polyethylene (the ratio of the mass of ethylene used for polymerizing the polyethylene to the mass of total monomers used for polymerizing the polyethylene) may preferably be 60 mass% or more, more preferably 70 mass% or more and 99.5 mass% or less, and most preferably 90 mass% or more and 99.5 mass% or less. The polyethylene contained in the resin layer (A) may be of one type or may comprise plural types.

The above polyethylene may preferably have a density at 23°C of 0.900 g/cm³ or more and 1.000 g/cm³ or less, more preferably 0.910 g/cm³ or more and 0.990 g/cm³ or less, and most preferably 0.920 g/cm³ or more and 0.980 g/cm³ or less.

The above polyethylene may preferably have a value of melt flow rate in compliance with JIS K7210: 1999 of 0.1 g/10 min or more and 10 g/10min or less at a temperature of 230°C and a load of 2.16 kgf, more preferably 0.5 g/10 min or more and 10 g/10 min or less, and most preferably 2.0 g/10 min or more and 7.0 g/10 min or less.

The tensile elastic modulus at 23°C of the polyethylene is not particularly limited, but may ordinarily be 1.0 GPa or less, preferably 0.4 GPa or less, and more preferably 0.2 GPa or less.

Measuring method for the tensile elastic modulus at 23°C of the polyethylene will be described. A polyethylene film may first be produced to have a thickness of 100 µm. The polyethylene film obtained in such a manner may be cut into a test specimen of 15 mm×140 mm, and tensile test can be performed with a rate of 200 mm/min to measure the tensile elastic modulus at 23°C in compliance with JIS K7161: 1994 and JIS K7127: 1999. This measurement of the tensile elastic modulus in the present embodiment may be performed in each of the extrusion direction (machine direction: MD) and the perpendicular direction thereto (cross machine direction: CD) at the time of forming the polyethylene film, and the average value of these measurement results is to represent the tensile elastic modulus at 23°C of the polyethylene.

The fluidization temperature of the polyethylene is not particularly limited, but may preferably be 100°C or more and 180°C or less in general. The fluidization temperature as used herein means a minimum temperature at which the fluidization of whole of a heated resin sample occurs when the sample is further heated beyond a state where the heated resin sample passes over a softening point thereby to increase the degree of freedom in deformation of molecules so that the intermolecular interaction is enhanced.

Measurement method for the fluidization temperature will be described more in detail. While the temperature of a sample is risen with a rate of temperature rise of 10°C/min, a stroke displacement rate (mm/min) which varies as the temperature rises is measured by setting a load of 49.05 N and using a die having a hole shape of ϕ2.0 mm and a length of 5.0 mm, and a temperature dependency chart of the stroke displacement rate is obtained. If the sample is a thermoplastic resin, then the stroke displacement rate increases with a trigger of the sample temperature reaching a softening point and reaches a certain peak, and thereafter once decreases. After reaching a minimum point due to this decrease, the stroke displacement rate increases rapidly because the fluidization of whole of the sample progresses. In the present embodiment, the fluidization temperature is defined, when the sample temperature is risen above the softening point, as a temperature that gives the minimum value of the stroke displacement rate which appears after the stroke displacement rate has once reached the peak.

The content of the polyethylene may preferably be 50 mass% or more and 90 mass% or less to total resin components contained in the resin layer (A), more preferably 55 mass% or more and 85 mass% or less, and most preferably 60 mass% or more and 80 mass% or less. If the content of the polyethylene in the resin layer (A) exceeds 95 mass%, then the suppressing effect for the occurrence of dicing debris may be observed to have a tendency to deteriorate. If the content of the polyethylene is less than 40 mass%, then problems may occur such that the expandability of the base film 2 becomes difficult to be enhanced and slack and/or blocking readily occur.

### (1-2) Ethylene-tetracyclododecene copolymer

The resin layer (A) possessed by the dicing sheet according to the present embodiment contains an ethylene-tetracyclododecene copolymer. In particular, the ethylene-tetracyclododecene copolymer may be a copolymer that comprises a constitutional unit originated from ethylene and a constitutional unit originated from tetracyclododecene, as represented by the structural formula (a) below. 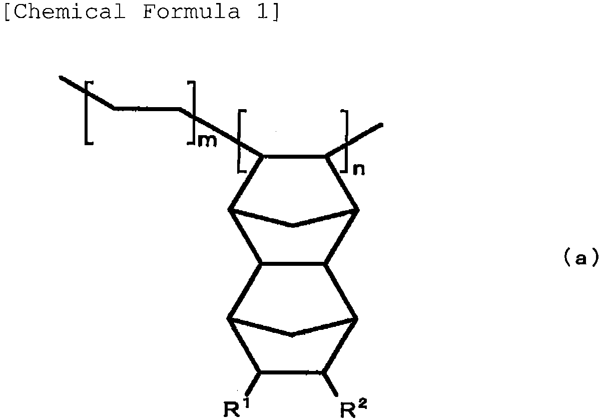 (where "m" and "n" are integers not less than 1, and "R¹" and "R²" each represent a hydrogen atom or an alkyl group, which may be or may not be the same.)

As a commercial product of such an ethylene-tetracyclododecene copolymer, a copolymer of ethylene and tetracyclododecene (APEL (registered trademark) series available from Mitsui Chemicals, Inc.) may be exemplified.

The resin layer (A) possessed by the dicing sheet according to the present embodiment contains the ethylene-tetracyclododecene copolymer, and can thereby suppress the occurrence of dicing debris. The ethylene-tetracyclododecene copolymer contained in the resin layer (A) may be of one type or may comprise plural types.

The ethylene-tetracyclododecene copolymer contained in the resin layer (A) may preferably be such that the constitutional unit originated from tetracyclododecene (the ratio of the mass of tetracyclododecene used for polymerizing the ethylene-tetracyclododecene copolymer to the total sum of the mass of ethylene and the mass of tetracyclododecene used for polymerizing the ethylene-tetracyclododecene copolymer) is 15 mol% or more and 45 mol% or less. If the constitutional unit originated from tetracyclododecene is 15 mol% or less, then the suppressing effect for the occurrence of dicing decries may be difficult to be obtained. If the constitutional unit originated from tetracyclododecene exceeds 45 mol%, then the glass-transition point may rise, and a tendency may be observed such as that the formability of the base film 2 deteriorates and the expandability deteriorates.

The ethylene-tetracyclododecene copolymer may also contain constitutional units originated from other compounds than those originated from ethylene and tetracyclododecene with such an extent that does not impair the advantageous effects of the present invention. It may be preferred that the mass ratio of monomers comprising such other compounds is less than 10 mass% to the mass of total monomers.

In view of such as suppressing efficiently the occurrence of dicing debris and enhancing the workability, the value of melt flow rate in compliance with JIS K7210: 1999 may preferably be 0.1 g/10 min or more at a temperature of 230°C and a load of 2.16 kgf, more preferably 0.5 g/10 min or more and 50.0 g/10 min or less, and most preferably 1.0 g/10 min or more and 25.0 g/10 min or less. If the melt flow rate is unduly high, then the workability such as forming of the base film 2 may even be excellent, but the functionality of suppressing the occurrence of dicing debris may easily deteriorate. If the melt flow rate is unduly low, then the workability such as forming of the base film 2 may become poor.

It may be preferred that the tensile elastic modulus at 23°C of the ethylene-tetracyclododecene copolymer contained in the resin layer (A) is more than 1.5 GPa. Details of the measuring method for the tensile elastic modulus are similar to those for the tensile elastic modulus at 23°C of the previously-described polyethylene. The tensile elastic modulus at 23°C of the ethylene-tetracyclododecene copolymer being within the above range allows the difference in physical characteristics from those of the polyethylene to be large, and it is expected that dicing debris is unlikely to occur. In view of stably suppressing the occurrence of dicing debris, it may be preferred that the tensile elastic modulus at 23°C of the ethylene-tetracyclododecene copolymer contained in the resin layer (A) is 2.0 GPa or more. The upper limit of the tensile elastic modulus at 23°C of the ethylene-tetracyclododecene copolymer contained in the resin layer (A) is not particularly limited in view of suppressing the occurrence of dicing debris, but if this tensile elastic modulus is unduly high, then the resin layer (A) is likely to embrittle, and chipping may readily occur at the time of dicing a cut object. Therefore, it may be preferred that the upper limit of the tensile elastic modulus at 23°C of the ethylene-tetracyclododecene copolymer contained in the resin layer (A) is 4.0 GPa or less.

The fluidization temperature of the ethylene-tetracyclododecene copolymer contained in the resin layer (A) is preferably 225°C or less, more preferably 200°C or less, and most preferably 180 °C or less. If the fluidization temperature is 225 °C or less, then it can more stably be achieved to prevent the occurrence of chipping and significant embrittlement of the resin layer (A) while efficiently suppressing the occurrence of dicing debris during dicing a cut object. If the fluidization temperature of the ethylene-tetracyclododecene copolymer contained in the resin layer (A) is unduly low, then it may be difficult to obtain an effect of suppressing the occurrence of dicing debris. In view of stably suppressing the occurrence of dicing debris, it may be preferred that the lower limit of the fluidization temperature of the ethylene-tetracyclododecene copolymer contained in the resin layer (A) is 100°C or more.

The content of the ethylene-tetracyclododecene copolymer in total resin compositions in the resin layer (A) may preferably be 10 mass% or more and 50 mass% or less, more preferably 15 mass% or more and 45 mass% or less, and most preferably 20 mass% or more and 40 mass% or less. If the above content of the ethylene-tetracyclododecene copolymer contained in the resin layer (A) is unduly low, then it may be difficult to stably obtain an effect of suppressing the occurrence of dicing debris. If the above content of the ethylene-tetracyclododecene copolymer is unduly high, then a tendency that the workability deteriorates may be observed. This may also cause the tensile elastic modulus of the resin layer (A) to be excessively high, so that the expandability of the base film 2 may deteriorate.

### (1-3) Other components in resin layer (A)

The resin layer (A) may contain other components in addition to the above polyethylene and ethylene-tetracyclododecene copolymer. Examples of such other components include thermoplastic elastomer resins, such as isoprene rubber, nitrile rubber, acrylic rubber, urethane rubber, butadiene rubber and styrene-based elastomer, polypropylene, and various additives, such as pigment, flame retardant, plasticizer, antistatic agent, glidant and filler.

### (2) Resin layer (B)

If the base film 2 has a multilayer structure, then, as shown in FIG. 2, the base film 2 may further comprise a resin layer (B) configured of at least one layer placed at one main surface side of the resin layer (A). In FIG. 2, the resin layer (B) contacts directly with the resin layer (A), but an interlayer for adhesion may be present between the resin layer (A) and the resin layer (B).

If the base film 2 comprises the resin layer (B) configured of at least one layer placed at one main surface side of the resin layer (A), then it can be possible to obtain an effect that the expandability of the base film 2 is further enhanced. The resin layer (B) may have a single layer structure or a multilayer structure.

Examples of resin that constitutes the resin layer (B) include: olefin-based resin; polyester such as polyethylene terephthalate and polyethylene naphthalate; polyurethane; polyvinyl chloride; and polyamide.

Among these resins, olefin-based resin may be preferable as the resin that constitutes the resin layer (B). If the resin that constitutes the resin layer (B) is olefin-based resin, then the adhesiveness of the resin layer (B) to the above-described resin layer (A) may be high, and delamination can be suppressed from occurring between the resin layer (A) and the resin layer (B).

Examples of the above olefin-based resin include polyethylene, polypropylene, polybutene, ethylene-propylene copolymer, ethylene-butene copolymer, ethylene-(meth)acrylic acid copolymer, ethylene-vinyl acetate copolymer, and ethylene-(meth)acrylic acid ester copolymer. One type of olefin-based resin may be solely used, or two or more types of resins may be blended to be used. The "(meth)acrylic acid" as used herein is intended to mean both acrylic acid and methacrylic acid.

Among these olefin-based resins, at least one type of ethylene-(meth)acrylic acid ester copolymer and ethylene-(meth)acrylic acid copolymer may preferably be contained in the resin that constitutes the resin layer (B) because they contribute to allowing the resin layer (B) to readily have enhanced toughness and to have enhanced adhesiveness to the resin layer (A).

The ethylene-(meth)acrylic acid copolymer may contain constitutional units originated from other compounds than constitutional units originated from ethylene, acrylic acid, and/or methacrylic acid to such an extent that does not impair the advantageous effects of the present invention. It may be preferred that the mass ratio of monomers comprising such other compounds is 10 mass% or less to the mass of total monomers.

It may be preferred that the resin layer (B) has a tensile elastic modulus of 50 MPa or more and 500 MPa or less and a fracture elongation of 100% or more at 23°C. The tensile elastic modulus and the fracture elongation at 23°C being within the above ranges allow the resin layer (B) to have excellent flexibility and expanding property thereby to give further enhanced expandability to the base film 2 configured of the resin layer (A) and the resin layer (B) laminated on each other.

If the tensile elastic modulus at 23°C of the resin layer (B) exceeds 500 MPa, then the resin layer (B) may deteriorate in its flexibility and readily fracture, so that the effect of further enhancing the expandability of the base film 2 may be difficult to be obtained. If the tensile elastic modulus at 23°C of the resin layer (B) is less than 50 MPa, then the handling ability may deteriorate. The tensile elastic modulus at 23°C of the resin layer (B) may more preferably be 55 MPa or more and 400 MPa or less, further preferably 60 MPa or more and 300 MPa or less, and most preferably 65 MPa or more and 200 MPa or less.

If the fracture elongation at 23°C of the resin layer (B) is less than 100%, then fracture may readily occur at the resin layer (B) when the dicing sheet 1 is expanded, so that the effect of further enhancing the expandability of the base film 2 may be difficult to be obtained. The fracture elongation at 23°C of the resin layer (B) may more preferably be 200% or more, and most preferably 300% or more. The upper limit of the fracture elongation at 23°C of the resin layer (B) is not particularly limited, but may ordinarily be 1,000% or less, and may also be about 800% or less.

The resin layer (B) may contain other components than the above resin to an extent that does not impair the advantageous effects of the present invention. Examples of such components include various additives, such as pigment, flame retardant, plasticizer, antistatic agent, glidant and filler. Examples of pigment include titanium dioxide and carbon black. Examples of filler include organic material such as melamine resin, inorganic material such as fumed silica, and metal-based material such as nickel particles.

### (3) Other features of base film

If, as shown in FIG. 1, the base film 2 has a single layer structure of the resin layer (A), then the thickness of the resin layer (A) (i.e., the base film 2) may ordinarily be about 20 µm or more and 600 µm or less, preferably 40 µm or more and 300 µm or less, and most preferably 60 µm or more and 200 µm or less.

If, as shown in FIG. 2, the base film 2 has a multilayer structure comprising the resin layer (B) configured of at least one layer placed at one main surface side of the resin layer (A), then the thickness of the resin layer (A) may ordinarily be about 10 µm or more and 300 µm or less, preferably 20 µm or more and 120 µm or less, and most preferably 30 µm or more and 100 µm or less. The thickness of the resin layer (A) being within the above range may stably suppress the occurrence of dicing debris. The thickness of the resin layer (B) may ordinarily be about 10 µm or more and 300 µm or less, preferably 40 µm or more and 120 µm or less, and most preferably 50 µm or more and 100 µm or less. The thickness of the base film 2 may ordinarily be about 20 µm or more and 600 µm or less.

The tensile elastic modulus at 23°C of the base film 2 according to the present embodiment may be 50 MPa or more and 1,000 MPa or less, and preferably 80 MPa or more and 1,000 MPa or more. If the tensile elastic modulus is less than 50 MPa, then the handling ability of the base film 2 may be poor. If the tensile elastic modulus at 23°C of the base film 2 exceeds 1,000 MPa, then problems may occur such as that the base film 2 fractures during the expanding process and that the dicing sheet 1 itself is peeled-off from a ring frame because the load applied during the expanding process increases.

### (4) Method of producing base film

Method of producing the base film 2 is not particularly limited. Examples thereof include: melt extrusion method, such as T-die method and round-die method; calender method; and solution method, such as dry method and wet method, and any method may be employed. Considering that both the polyethylene and the ethylene-tetracyclododecene copolymer contained in the resin layer (A) are thermoplastic resins, it may be preferred to employ the melt extrusion method or the calender method. Among them, if the melt extrusion method is employed for production, then components to constitute the resin layer (A) may be kneaded, and film forming may be performed using a known extruder directly from the obtained kneaded components or from pellets which have been once produced from the obtained kneaded components.

Also in the case where the base film 2 comprises the resin layer (B) configured of at least one layer placed at one main surface side of the resin layer (A), the production method is not particularly limited, and may freely selected. Any method may be employed depending on the composition of the resin layer (B) and purposes. For example, the resin layer (A) and the resin layer (B) may be laminated on each other by using coextrusion, or separately produced resin layers may be applied to each other such as by adhesive so as to be laminated.

### 2. Dicing sheet

The dicing sheet 1 according to the present embodiment comprises the base film 2 according to the present embodiment and the pressure-sensitive adhesive layer 3 placed on one main surface of the base film 2.

When, as shown in FIG. 2, the base film 2 comprises the resin layer (B) configured of at least one layer placed at one main surface side of the resin layer (A), the dicing sheet 1 may preferably be such that the resin layer (A) of the base film 2 is placed more proximal to the pressure-sensitive adhesive layer 3 than the resin layer (B), and may more preferably be such that the pressure-sensitive adhesive layer 3 is placed on the resin layer (A) of the base film 2. This may further efficiently suppress the occurrence of dicing debris during dicing a cut object.

### (1) Pressure-sensitive adhesive layer

Pressure-sensitive adhesive that constitutes the pressure-sensitive adhesive layer 3 possessed by the dicing sheet 1 according to the present embodiment is not particularly limited, and examples thereof to be used include known pressure-sensitive adhesives, such as rubber-based, acrylic-based, epoxy-based, silicone-based and polyvinyl ether-based pressure-sensitive adhesives, energy ray curable-type pressure-sensitive adhesive (including ultraviolet curable-type pressure-sensitive adhesive), and heat curable-type pressure-sensitive adhesive. If the dicing sheet 1 according to the present embodiment is used as a dicing/die-bonding sheet, then an adhesive which has both the wafer fixing functionality and the die fixing functionality may be used as the pressure-sensitive adhesive layer 3.

The thickness of the pressure-sensitive adhesive layer 3 may ordinarily be about 3 µm or more and 100 µm or less, and preferably 5 µm or more and 80 µm or less.

### (2) Release sheet

To protect the pressure-sensitive adhesive layer 3 possessed by the dicing sheet 1 according to the present embodiment, a release sheet may be applied to the opposite surface of the pressure-sensitive adhesive layer 3 to the surface facing the base film 2. The release sheet will be released when the dicing sheet 1 is used. The release sheet is not particularly limited, and a release sheet may be used, for example, which has a release layer subjected to release treatment using a known release agent on a support member such as a polyethylene terephthalate film.

### (3) Method of producing dicing sheet

The method of producing the dicing sheet 1 according to the present embodiment is not particularly limited. Some exemplary methods of producing the dicing sheet 1 may be as follows.
(i) The pressure-sensitive adhesive layer 3 is formed on the release sheet, and the base film 2 is pressed and bonded onto the pressure-sensitive adhesive layer 3 to be laminated. In this operation, the method of forming the pressure-sensitive adhesive layer 3 may be freely selected.
   One exemplary method of forming the pressure-sensitive adhesive layer 3 may be as follows. A coating agent is prepared which contains a pressure-sensitive adhesive that constitutes the pressure-sensitive adhesive layer 3 and if necessary further contains some solvent. The coating agent is applied to one main surface of the base film 2 using a coater, such as roll coater, knife coater, roll knife coater, air knife coater, die coater, bar coater, gravure coater or curtain coater, and dried thereby to form the pressure-sensitive adhesive layer 3.
(ii) The pressure-sensitive adhesive layer 3 is formed on the base film 2, and if necessary a release sheet is further laminated thereon. In this operation, method of forming the pressure-sensitive adhesive layer 3 may be freely selected as the above.
   As example other than the above methods of (i) and (ii), a pressure-sensitive adhesive layer 3 separately formed in a sheet-like form may also be applied to the base film 2.

The base film 2 and the dicing sheet 1 according to the present embodiment can effectively reduce dicing debris to be generated during dicing a cut object without imparting physical energy, such as electron beam or γ ray, and have enhanced expandability.

It is to be noted that the embodiments as heretofore explained are described to facilitate understanding of the present invention and are not described to limit the present invention. Therefore, it is intended that the elements disclosed in the above embodiments include all design changes and equivalents to fall within the technical scope of the present invention.

### [Examples]

The present invention will hereinafter be more specifically described with reference to examples etc, but the scope of the present invention is not to be limited to these examples etc.

Material used in each example is listed below.
<Resin layer (A)>
   - Polyethylene A (product name: SUMIKATHENE (registered trademark) L705 available from Sumitomo Chemical Company, Limited, density at 23°C: 0.919 g/cm³)
   - Polyethylene B (product name: EXCELLEN EUL731 available from Sumitomo Chemical Company, Limited, density at 23°C: 0.895 g/cm³)
   - Ethylene-tetracyclododecene copolymer A (product name: APL6509T (registered trademark) available from Mitsui Chemicals, Inc., constitutional unit originated from tetracyclododecene: 20-32 mol%)
   - Ethylene-tetracyclododecene copolymer B (product name: APL6011T (registered trademark) available from Mitsui Chemicals, Inc., constitutional unit originated from tetracyclododecene: 24-36 mol%)
   - Ethylene-tetracyclododecene copolymer C (product name: APL6013T (registered trademark) available from Mitsui Chemicals, Inc., constitutional unit originated from tetracyclododecene: 29-40 mol%)
   - Ethylene-tetracyclododecene copolymer D (product name: APL8008T (registered trademark) available from Mitsui Chemicals, Inc., constitutional unit originated from tetracyclododecene: 16-28 mol%)
   - Polypropylene (product name: Prime Polypro (registered trademark) F-704NT available from Prime Polymer Co., Ltd., density at 23°C: 0.90 g/cm³)
<Resin layer (B)>
   - EMMA (ethylene-methyl methacrylate copolymer, ACRYFT (registered trademark) W201 available from Sumitomo Chemical Company, Limited)
   - EMAA (ethylene-methacrylic acid copolymer, product name: Nucrel (registered trademark) N0903HC available from DUPONT-MITSUI POLYCHEMICALS CO., LTD., content of acid originated from MAA: 9 mass%)

### <Example 1>

### (Preparation of base film)

Raw material for extrusion of the resin layer (A) was obtained by melting and kneading 70 mass parts of the polyethylene A and 30 mass parts of the ethylene-tetracyclododecene copolymer A using a biaxial kneading machine (Labo-plastomill available from Toyo Seiki Seisaku-sho, LTD).

Raw material for extrusion of the resin layer (B) was obtained by melting and kneading the EMMA using a biaxial kneading machine (product name: Labo-plastomill available from Toyo Seiki Seisaku-sho, LTD).

The raw material for extrusion of the resin layer (A) and the raw material for extrusion of the resin layer (B) were subjected to coextrusion forming using a compact T die extruder (product name: Labo-plastomill available from Toyo Seiki Seisaku-sho, LTD.), and a base film of two-layer structure comprising the resin layer (A) having a thickness of 40 µm and the resin layer (B) having a thickness of 60 µm was obtained.

### (Preparation of pressure-sensitive adhesive)

An energy ray curable-type pressure-sensitive adhesive composition was obtained by mixing 100 mass parts of copolymer (Mw: 500,000) provided by copolymerization of 95 mass parts of n-butyl acrylate and 5 mass parts of acrylic acid, 120 mass parts of urethane acrylate oligomer (Mw: 8,000), 5 mass parts of isocyanate-based curing agent (Coronate L available from NIPPON POLYURETHANE INDUSTRY CO., LTD.), and 4 mass parts of photopolymerization initiator (IRGACURE 184 available from Ciba Specialty Chemicals Inc).

The obtained energy ray curable-type pressure-sensitive adhesive composition was applied to the release treatment surface of a release film treated with silicone release treatment (SP-PET38111(S) available from LINTEC Corporation) to have a film thickness after drying of 10 µm, and dried under 100°C for 1 minute to form a pressure-sensitive adhesive layer, which was then applied to the surface of the above base film at the side of the resin layer (A) thereby to transfer the pressure-sensitive adhesive layer to the base film, and a dicing sheet was thus obtained.

### <Examples 2 to 8 and Comparative Examples 2 and 3>

Dicing sheets were produced like in Example 1 except for changing materials for the resin layer (A) and the resin layer (B) and the compounding amounts to those listed in Table 1.

Compositions of the above examples and comparative examples are collectively listed in Table 1. Each numerical value in Table 1 represents the mass parts of each component.

**[Table 1]**

| Resin layer | Constitutional resin type | Example | | | | | | | | Comparative Example | | |
|---|---|---|---|---|---|---|---|---|---|---|---|---|
| | | 1 | 2 | 3 | 4 | 5 | 6 | 7 | 8 | 1 | 2 | 3 |
| (A) | Ethylene-tetracyclododecene copolymer A | 10 | 30 | 50 | - | 30 | 30 | - | - | - | - | - |
| | Ethylene-tetracyclododecene copolymer B | - | - | - | 30 | - | - | - | - | - | - | - |
| | Ethylene-tetracyclododecene copolymer C | - | - | - | - | - | - | 30 | - | - | - | - |
| | Ethylene-tetracyclododecene copolymer D | - | - | - | - | - | - | | 30 | - | - | - |
| | Polyethylene A | 90 | 70 | 50 | 70 | 70 | 70 | 70 | 70 | - | 100 | - |
| | Polyethylene B | - | - | - | - | - | - | - | - | - | - | 70 |
| | Polypropylene | - | - | - | - | - | - | - | - | 100 | - | 30 |
| (B) | EMMA | 100 | 100 | 100 | 100 | - | - | 100 | 100 | - | - | - |
| | EMAA | - | - | - | - | 100 | 100 | - | - | 100 | - | - |
| Observation of dicing debris <Condition 1> | | A | A | A | A | A | A | A | A | B | C | B |
| Observation of dicing debris <Condition 2> | | A | A | A | A | A | A | A | A | C | C | C |
| Expandability | | A | A | A | A | A | A | A | A | A | A | A |

### <Exemplary Test 1> (Observation of dicing debris)

With respect to each of dicing sheets produced according to the examples and the comparative examples, after applying the surface thereof at the side of the pressure-sensitive adhesive layer to an uncut adherend and then setting them on a dicing apparatus (DFD-651 available from DISCO Corporation), dicing was performed under the two conditions below:
«Condition 1»
   - work (adherend): silicon wafer;
   - work size: 6 inches diameter, 350 µm thickness;
   - dicing blade: 27HEEE available from DISCO Corporation;
   - blade rotating speed: 50,000 rpm;
   - dicing speed: 10 mm/sec;
   - cut-into depth: cutting into the base film with a depth of 20 µm from the interface with the pressure-sensitive adhesive layer; and
   - dicing size: 10 mm×10 mm, and
«Condition 2»
   - work (adherend): silicon wafer; and
   - work size: 6 inches diameter, 100 µm thickness; cutting into with a depth of 50 µm from the wafer surface under the condition below,
   - dicing blade: 27HEFF available from DISCO Corporation;
   - blade rotating speed: 5,000 rpm; and
   - dicing speed: 100 mm/sec; then further cutting into the base film with a depth of 20 µm from the interface with the pressure-sensitive adhesive layer under the condition below,
      - dicing blade: 27HEEE available from DISCO Corporation;
      - blade rotating speed: 3,500 rpm;
      - dicing speed: 100 mm/sec; and
      - dicing size: 10 mm×10 mm.

Thereafter, the cut chips were removed by irradiating ultraviolet rays (160 mJ/cm²) from the base film side. Among lengthwise and breadthwise dicing lines, one lengthwise line and one breadthwise line located near the respective centers were subjected to a test where the number of filament-like debris particles of a length of 100 µm or more occurring on each line was counted using a digital microscope (VHX-100 available from KEYENCE CORPORATION, magnification: ×100). Measurement results were evaluated according to the criteria below. Evaluation results are listed in Table 1.
A: the number of filament-like debris particles was 0 to 10
B: 11 to 15
C: 16 or more

### <Exemplary Test 2> (Expandability test)

With respect to each of dicing sheets produced according to the examples and the comparative examples, after applying the surface thereof at the side of the pressure-sensitive adhesive layer to a 6-inch silicon wafer, the dicing sheet was attached to a flat frame and the wafer was fully cut into chips of 10 mm square using a diamond blade of 20 µm thickness. The dicing sheet was then pulled down 10 mm with a speed of 60 mm/min using an expanding jig (Die Bonder CSP-100VX available from NEC Machinery Corporation). Presence or absence of fracture of the dicing sheet at that time was confirmed. Results were evaluated according to the criteria below. Evaluation results are listed in Table 1.
A: when fracture was not confirmed
B: when fracture was confirmed

As apparent from Table 1, dicing sheets produced according to the examples had few dicing debris particles during the dicing process and also had excellent expandability during the expanding process.

### [Industrial Applicability]

The base film for a dicing sheet and the dicing sheet according to the present invention can be preferably used for dicing of semiconductor wafers and various kinds of packages etc.

### [Description of Reference Numerals]

- 1...: Dicing sheet
- 2...: Base film (Resin layer (A)/Resin layer (B))
- 3...: Pressure-sensitive adhesive layer

## Claims

1. A base film for a dicing sheet, the base film comprising a resin layer (A), wherein
the resin layer (A) comprises a polyethylene and an ethylene-tetracyclododecene copolymer.

2. The base film for a dicing sheet as recited in claim 1, wherein the polyethylene has a content of 50 mass% or more and 90 mass% or less and the ethylene-tetracyclododecene copolymer has a content of 10 mass% or more and 50 mass% or less to total resin components contained in the resin layer (A).

3. The base film for a dicing sheet as recited in claim 1 or 2, wherein the ethylene-tetracyclododecene copolymer has a constitutional unit originated from tetracyclododecene of 15 mol% or more and 45 mol% or less.

4. The base film for a dicing sheet as recited in either one of claims 1 to 3, wherein the base film further comprises a resin layer (B) placed at one main surface side of the resin layer (A) and the resin layer (B) comprises at least one layer.

5. The base film for a dicing sheet as recited in claim 4, wherein the resin layer (B) comprises at least one of ethylene-(meth)acrylic acid ester copolymer and ethylene-(meth)acrylic acid copolymer.

6. A dicing sheet comprising: the base film as recited in either one of claims 1 to 5; and a pressure-sensitive adhesive layer placed on one main surface of the base film.

7. The dicing sheet as recited in claim 6, wherein the pressure-sensitive adhesive layer is placed on the resin layer (A) of the base film.

8. A dicing sheet comprising: the base film as recited in claim 4 or 5; and a pressure-sensitive adhesive layer placed on one main surface of the base film, wherein
the resin layer (A) is placed more proximal to the pressure-sensitive adhesive layer than the resin layer (B).
